Europäisches Patentamt

(19) European Patent Office

Office européen des brevets

(11) Publication number: **0 145 926**
**B1**

(12) **EUROPEAN PATENT SPECIFICATION**

(45) Date of publication of patent specification: **27.07.88**

(51) Int. Cl.⁴: **H 01 L 21/31**, H 01 L 21/265

(21) Application number: **84113320.0**

(22) Date of filing: **06.11.84**

(54) **Polysilicon resistors compensated with double ion-implantation.**

<table>
<tr><td>

(30) Priority: **15.11.83 US 552191**

(43) Date of publication of application:
**26.06.85 Bulletin 85/26**

(45) Publication of the grant of the patent:
**27.07.88 Bulletin 88/30**

(84) Designated Contracting States:
**DE FR GB**

(56) References cited:
**EP-A-0 112 097**
**US-A-4 201 603**
**US-A-4 411 708**
**US-A-4 489 104**

**PATENTS ABSTRACTS OF JAPAN, vol. 5, no. 145 (E-74)817r, 12th September 1981
IBM TECHNICAL DISCLOSURE BULLETIN, vol. 25, no. 3B, August 1982, pages 1476-1477, New York, US; C.H. LEE: "Polysilicon resistor fabrication technique for bipolar integrated circuits"**

</td><td>

(73) Proprietor: **International Business Machines Corporation**
**Old Orchard Road**
**Armonk, N.Y. 10504 (US)**

(72) Inventor: **Choi, Min Sung**
**32 Gerry Road**
**Poughkeepsie New York 12603 (US)**
Inventor: **Fitzpatrick, Desmond A.**
**14 Pocantico Road**
**Ossining New York 10562 (US)**

(74) Representative: **Mönig, Anton, Dipl.-Ing.**
**IBM Deutschland GmbH Schönaicher Strasse 220**
**D-7030 Böblingen (DE)**

</td></tr>
</table>

## Description

The invention relates generally to polysilicon resistors, and it relates, in particular, to polysilicon resistors of high reliability and reproducibility.

The use of polycrystalline silicon, or polysilicon as it is commonly known, as a resistive element is well known in the fabrication of integrated circuits. For instance, Heeren in U.S. Patent 4,285,117 describes a method of manufacturing an integrated circuit that includes both an insulated gate field-effect transistor and its associated load resistor. Heeren used a layer of polysilicon for the load resistor. Heeren controls the resistance of the polysilicon load resistor by diffusing into it conductivity modifiers or dopants. The implantation of polysilicon with nitrogen or oxygen to increase its resistivity is described in Japanese Patent 55-82458. On the other hand, Bean et al in U.S. Patent 3,570,114 decrease the resistivity of polysilicon by the implantation of either phosphorus or boron. Bean also describes the selective control of the conductivity type of the polysilicon by selectively implanting with acceptor or donor dopant impurities.

Seto in an article entitled "The Electrical Properties of Polycrystalline Silicon Films", in the *Journal of Applied Physics*, Vol. 46, 1975, pp. 5247—5254, describes the dependence of the resistivity of polysilicon with doping concentration. The slope of this dependence is very steep with the result that extreme care must be exercised during manufacture to closely control the value of resistivity. Furthermore, small variations in temperature will produce large variations in the resistivity, that is, the temperature coefficient is very large.

These properties introduce problems with the use of polysilicon resistors. Minor and perhaps uncontrollable variations in materials and of processing during fabrication of the polysilicon resistors introduce large variations in the polysilicon resistance. If an acceptable yield is to be maintained, the design must allow for a wide range of resistances. Such wide ranges are inconsistent with high performance devices. Furthermore, the device incorporating a polysilicon resistor is expected to operate at a fairly wide range of temperatures. A large temperature coefficient for resistance causes correspondingly large variations in resistance. The design must then again allow for the wide resistance range or the operating temperatures are unacceptably restricted.

Control of these resistivity variations requires an understanding of the conduction mechanism. Seto, in the above-cited article, concludes that conduction in polysilicon is controlled by trapping states at the grain boundaries of the polysilicon. In another article entitled "Modeling and Optimization of Monolithic Polycrystalline Silicon Resistors", in *IEEE Transactions on Electron Devices*, Vol. ED-28, 1981, pp. 818—830, Lu et al expand on the conduction model and the temperature effect. Another type of resistor used in integrated circuits is a semiconductor resistor, e.g. of silicon. Silicon resistors as well, because of the semiconducting nature, have a large temperature coefficient of resistivity. In U.S. Patent 3,683,306 Bulthius et al describe a method of reducing the temperature dependence of the resistivity. Bulthius et al introduce two types of dopants into the silicon, an acceptor or donor dopant, such as boron or phosphorous, and an electrically inactive dopant, such as tin. There is no compensation between the two dopants. But the electrically inactive dopant causes additional scattering. In an article entitled "New Techniques for Improving High Value Ion Implanted Resistors", published in *Ion Implantation in Semiconductors; Proceedings of the 2nd International Conference on Ion Implantation in Semiconductors*, Springer-Verlag, Berlin, 1971, pp. 357—361, Nicholas et al describe a similar double doping with an electrically active and an electrically inactive dopant. They implant silicon with both boron and neon.

The use of ion implantation to improve the reliability of polysilicon resistors has been uncertain because its conduction mechanisms are so different from single crystal silicon.

The invention as claimed solves the problem of providing polysilicon resistors of high reliability and of reproducible resistance. Further, the invention is to provide polysilicon resistors that have a low value for the temperature coefficient of resistivity.

The invention is described in more detail below with reference to drawings which are to be understood as illustrative embodiments only.

In the drawings:

Fig. 1 is a semi-logarithmic plot of the sheet resistance of polysilicon resistors as a function of the inverse net doping concentration. Both prior art resistors and resistors built according to this invention are displayed.

Fig. 2 is a semi-logarithmic plot of the sheet resistance as a function of a net doping concentration for five compensated polysilicon resistors with different background doping concentrations.

Fig. 3 is a plot of the temperature coefficient of resistance as a function of sheet resistance for both uncompensated polysilicon resistors and compensated polysilicon resistors built according to this invention.

Fig. 4 is a cross-section of a partially fabricated compensated polysilicon resistor.

Fig. 5 is a cross-section of a completed compensated polysilicon resistor built according to this invention.

Polysilicon is a polycrystalline material and is therefore composed of crystallites of different sizes. Each crystallite has a certain crystallographic orientation and is joined to its neighbors through grain boundaries, disordered atomic layers of approximately 1 nm thickness. The electrical conduction mechanisms and the band structure of the polycrystalline semiconductor are modified by the grain boundaries. The most widely accepted conduction mechanism is the carrier trapping model as described in the previously cited article by Lu et al. The grain boundaries contain carrier trapping sites located at an energy $E_T$ with respect to the intrinsic fermi level of the polycrystallite. The density of the trapping sites is measured as a surface charge $Q_T/cm^2$. The band structure of single crystal silicon can be applied to the polysilicon except in the vicinity of the grain boundaries. When the polysilicon is doped with N- or P-type materials, the neutral traps become charged by trapping the carriers and thus depleting the polycrystallite near the grain boundaries.

As a result, a potential barrier $V_B$ is built up near the grain boundaries due to the charged traps. The depletion layer width is changed by the amount of charge trapped. Consequently the effective carrier concentration and the conductivity of the polysilicon are significantly reduced by the grain-boundary effects. The electrical conduction mechanism is assumed to arise mainly from the thermionic emission of effective carriers over the grain boundary potential. The mobility minimum of carriers and the steep slope of the sheet resistance $R_S$ as a function in polysilicon is due to the existence of this potential barrier. Sheet resistance is a measure of resistivity particuarly useful for thin films typical of polysilicon. It is the resistance for a given thickness film of unit width and unit height. Sheet resistance is expressed as ohms or ohms per square.

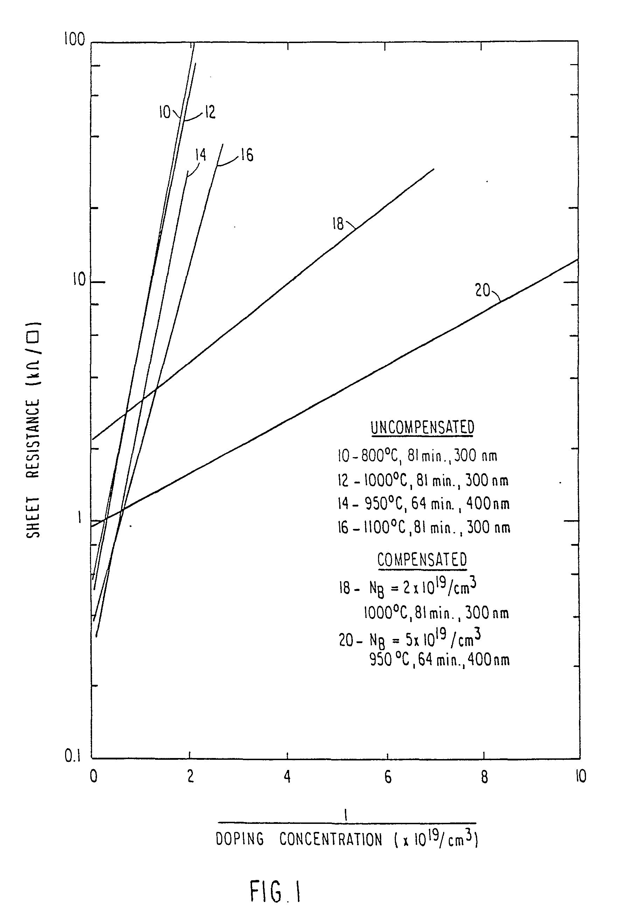

The greatest sensitivity of $R_S$ to ion implantation dose occurs at intermediate doping levels ($2\times10^{18}$—$10^{19}/cm^3$) because at these concentrations the grain boundary trapping sites are not yet saturated and the potential barrier height is still increasing. This range of concentration is the range used for high value $R_S$ resistors. At even higher doping levels, the grain boundaries are saturated and both the depletion layer width and the potential barrier height are reduced, resulting in a decrease in sensitivity of $R_S$ to dose. We have fabricated several polysilicon resistors according to prior art techniques by ion implanting polysilicon with boron and have measured their sheet resistances. These results are plotted in Fig. 1 as a function of inverse doping concentration for four different growth conditions of the polysilicon resistor, as represented by lines 10, 12, 14 and 16. The polysilicon was deposited to two different thicknesses, 300 nm for the resistors represented by lines 10, 12 and 16 and 400 nm for the resistor represented by line 14. Each of these resistors were annealed at an annealing temperature for an annealing time as described in the legend of Fig. 1. Similar plots are presented by Lu et al, and by Seto, who have experimentally determined the sheet resistances over a wider range of doping concentrations. The doping concentration range presented in Fig. 1 is the range which provides the higher sheet resistances particularly desirable for many applications in integrated circuits. It is seen that variations of a factor of 2 in doping concentration produces nearly a factor of 10 change in the sheet resistance. This extreme dependence on doping concentration makes it difficult to control the sheet resistance in the industrial production of polysilicon resistors.

We believe that the understanding of the mechanism for conduction in polysilicon can be exploited to provide polysilicon resistors which have a sheet resistance less sensitive to changes in the doping concentration. The basic mechanism of conduction remains the same. However, it is proposed to compensate the doping in the polysilicon, that is, to provide both N-type dopants and P-type dopants, with the net doping concentration being the difference between the two doping levels. As a result, the grain boundary traps are charged with both kinds of carriers, electrons and holes. The effect of compensation in single crystal silicon is relatively insignificant with the conduction properties being determined primarily by net or compensated doping levels. However, in polysilicon, if both kinds of carriers are trapped at the grain boundaries, the effective barrier height at the grain boundary is lowered by the compensated doping even though the net effect of doping is determined by how much one doping concentration exceeds the other. Since electrical conduction is very sensitive to the grain boundary potential height, a slight decrease in potential can greatly modify the sensitivity of the sheet resistance to the net doping concentration.

To prove the validity of this approach, two additional polysilicon resistors were fabricated similar to the prior art polysilicon resistors whose characteristics are shown in Fig. 1. However, both these resistors were given a background doping by ion implantation with an acceptor dopant, boron, and then another ion implantation was performed with a donor dopant, phosphorous, i.e., of the opposite conductivity type. The details of the processing are described later. The resistivity characteristics of these two example resistors are shown in Fig. 1. One resistor, whose characteristics are represented by line 18, was given a background doping of $2\times10^{19}/cm^3$. A second ion implantation of the opposite type was then performed to give a net doping concentration of $5\times10^{18}/cm^3$ and $10^{19}$. Line 18 was then drawn based on these two experimental points. The thickness of the polysilicon and the annealing conditions were the same as for the uncompensated resistor represented by line 12. The net doping concentration $N_A$—$N_D$, plotted in Fig. 1 is the difference between the background doping and the doping introduced by the second ion implantation. As is evident from Fig. 1, the dependence of the sheet resistance upon the net doping concentration is markedly reduced by the use of compensation. A second compensated polysilicon resistors was fabricated with a background doping of $5\times10^{19}/cm^3$ and its resistivity characteristics are represented by line 20. Its thickness of polysilicon and its annealing conditions are similar to the uncompensated resistor represented by line 14. Once again, the dependence upon doping concentration is reduced. Further, the experiments demonstrate that increased background doping further decreases the concentration dependence of the sheet resistance.

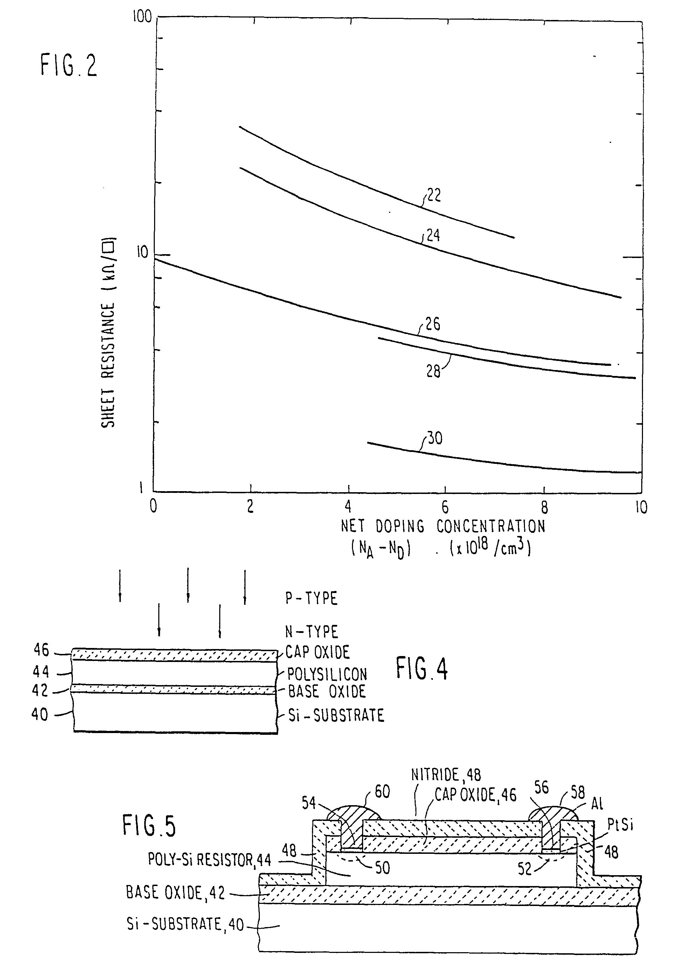

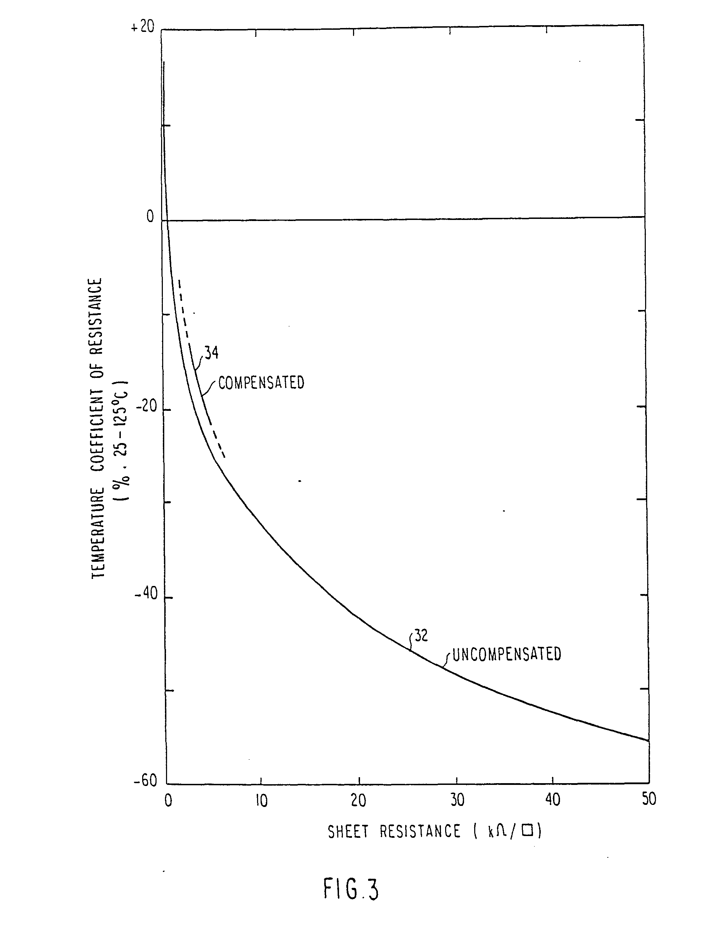

A further comparison was made with five compensated polysilicon resistors whose resistivity characteristics as a function of net doping concentration are shown in Fig. 2. For the first of these, a polysilicon layer of 300 nm thickness was deposited upon a substrate. Ion implantation of acceptor dopants produced a background doping of $7.3 \times 10^{18}$/cm$^3$. A second ion implantation of donor dopants was performed to produce the net doping concentrations indicated in Fig. 2. The sample was then annealed at 1,000°C for 81 minutes. Curve 22 connects the experimentally determined points. As is seen in this figure, the dependence of the sheet resistance upon the doping concentration is gradual. A second polysilicon resistor was produced similarly to that of curve 22 except that the background doping of acceptors was increased to $9.1 \times 10^{18}$/cm$^3$. These results are plotted by curve 24. A third and similar polysilicon resistor was fabricated with a background doping of $2 \times 10^{19}$/cm$^3$ and its resistivity characteristics are shown by curve 26. As can be seen from these three curves 22, 24 and 26, an increase in the background doping both lowers the sheet resistance for a given net doping concentration and also tends to reduce the dependence of the sheet resistance upon the net doping concentration.

A fourth polysilicon resistor was fabricated identically to that represented by curve 26 except that yet another ion implantation with boron was performed at the contact areas of the resistors to facilitate contacting of the resistor. They also receive an additional anneal at 900°C for 30 minutes. The resistivity characteristics of this resistor are shown by curve 28, which demonstrates that the additional contact ion implantation has minor effect upon the sheet resistance. A fifth resistor was fabricated with a background doping of acceptors of $5 \times 10^{19}$/cm$^3$ and was annealed at 950°C for 64 minutes. Contact ion implantation and annealing was also performed on this resistor. The resistivity characteristics are shown in curve 30. This curve 30 represents the characteristics for the same sample as does line 20 of Fig. 1.

As mentioned previously, a decrease in the dependence of the resistivity upon doping concentration should not only provide increased controllability of the resistor during fabrication but should also yield a slightly lower or at least equivalent dependence of the resistivity upon temperature. A large temperature coefficient of resistivity causes design problems because integrated circuits are typically designed to operate over a wide range of operating temperatures. Fig. 3 shows the temperature coefficient of resistivity as a function of sheet resistance for uncompensated polysilicon resistors in curve 32 and for examples of compensated polysilicon resistors in curve 34. The temperature coefficient of resistivity, as plotted in Fig. 3 is the percentage change in sheet resistance measured between 25 and 125°C.

It is seen that the temperature coefficient of resistivity for the compensated resistors is somewhat less in magnitude than that for the uncompensated resistors.

A process will now be described for fabricating polysilicon resistors. This process was used to fabricate the resistors used for the previously described experiments. However, it is to be understood that the invention is not limited to polysilicon resistors fabricated by this process alone.

The initial steps in fabricating a compensated polysilicon resistor are illustrated in Fig. 4. A slice of single crystal silicon is used as a substrate 40 which is thermally oxidized to form a base oxide layer 42 onto which the polysilicon resistors will be built. On top of the base oxide 42 a layer of polysilicon 44 is deposited by low pressure chemical vapor deposition. In the previously mentioned examples, this layer of polysilicon 44 is in the range of 300—400 nm. On top of the polysilicon 44, a cap oxide 46 is grown by thermal oxidation or by other means. The purpose of the cap oxide 46 is to protect the polysilicon layer 44. Then two ion implantations are performed. Each of the implantations reach through the cap oxide 46 to dope the underlying polysilicon layer 44. One of these implantations is a P-type dopant and the other is an N-type dopant, in this case boron and phosphorous are used. The order of the implantations seems unimportant although in the fabrication of the above-described resistors the heavy background doping of boron was performed before that of the phosphorous. It would also be possible to implant both ions simultaneously using the dual ion implanter described by Boroffka et al in U.S. patent 3,909,305. It is important that the dosages of the two ion implantations be carefully controlled because it is the difference between the two dopant concentrations which determines the net doping concentration and thus the net carrier density. Ion implantation, as performed in the state of the art, can control dosage within 1% which is compatible with the practice of this invention. As an example, if polysilicon resistors with a sheet resistance of 10 kilohms per square are desired, an uncompensated polysilicon resistor requires doping in the vicinity of $8 \times 10^{18}$/cm$^3$. At this doping range however, the $R_s$ variation for uncompensated polysilicon resistors was found to be very high. However, if the same sheet resistance values are to be obtained with compensated polysilicon resistors, the doping concentrations can be $9.1 \times 10^{18}$/cm$^3$ of boron and $2.9 \times 10^{18}$/cm$^3$ of phosphorous (see curve 24 of Fig. 2). At these doping levels, there is no control problem associated with $R_s$ sensitivity to doping concentration. The ion implanted polysilicon, as well as its associated structure, are then annealed to remove the damage introduced by the ion implantation. Typical annealing conditions were described in the discussions of Figs. 1 and 2.

At this point, the resistance characteristics of the polysilicon resistor have been established.

However, it remains to define the resistor and to establish contacts to it. A first pattern of photoresist is applied which defines the lateral extent of the polysilicon resistor, shown in Fig. 5. Then reactive ion etching removes the cap oxide 46 and the polysilicon 44 to physically define the extent of the polysilicon resistor. The first photoresist pattern is then stripped.

A layer of nitride 48 is then deposited over the entire chip. One of the purposes of the nitride 48 is to cover the walls of the polysilicon 44 exposed in the previously active ion etching. Then a second pattern of photoresist is applied which defines the contact areas at either end of the polysilicon resistor. Then a relatively heavy dose of the background dopant is ion implanted through the nitride 48 and the cap oxide 46 into the two contact regions 50 and 52 at the upper surface at the two ends of the polysilicon resistor. The final doping concentration in these contact areas 50 and 52 should be greater than $10^{20}/cm^3$. After the contact ion implantation, a second reactive ion etching removes the nitride 48 and the cap oxide 46 in the vicinity of the contact areas 50 and 52 which are not covered by the photoresist pattern. This etch exposes the contact areas 50 and 52 of the polysilicon 44 to subsequent contacting. The photoresist pattern is then stripped. The effect of the contact ion implantation is to provide dependable ohmic contact at the two contact areas 50 and 52.

The chip is then subjected to a second anneal, a contact anneal to remove the damage introduced by the contact ion implantation. The conditions of the contact anneal generally correspond to those of the first anneal. Of course, if no ion implantation were performed preparatory to making the contact, then the contact anneal is not necessary. After the contact anneal, the entire chip is dipped for a buffered HF etch. In a final series of steps, electrical contacts 54 and 56 are formed by depositing platinum using either electron gun evaporation or sputtering. The platinum contacts 54 and 56 are then sintered to form thin layers of platinum silicide (PtSi). Then aluminum leads 58 and 60 can be deposited for electrical connection. The fabrication of the device is thus completed and the device is ready for use or measurement.

It was found, using the above described technique, that the variation in the sheet resistivity for a given doping concentration was tight, having a standard deviation of between 2 and 3%.

Although what has been described is a compensated polysilicon resistor with a high background doping of boron and a lower doping of phosphorous so that the net doping is P-type, compensated polysilicon resistors of this invention can be fabricated with a higher N-type concentration than a P-type concentration. Furthermore, the doping species can be varied to include combinations such as boron-arsenic and boron-antimony.

Claims

1. A compensated polysilicon resistor, comprising an insulating base (42) and a layer (44) of polysilicon overlaying said insulating layer, said polysilicon layer having a predetermined width, and a predetermined length between two contact areas, said polysilicon layer comprising:
   a P-type dopant of a predetermined acceptor concentration included in said polysilicon layer substantially uniform over said length; and
   an N-type dopant of a predetermined donor concentration included in said polysilicon layer substantially uniform over said length, with the net dopant concentration being the difference between said first and second concentrations, whereby the sensitivity of the sheet resistance of the polysilicon upon the net doping concentration is greatly reduced.

2. The polysilicon resistor as recited in claim 1, further comprising a layer (46) of silicon oxide overlaying said polysilicon layer (44).

3. The polysilicon resistor as recited in claims 1 or 2, further comprising a contact dopant of the type of the P-type or N-type dopant having the higher concentration, said contact dopant being included in a portion (50, 52) of said polysilicon layer (44) near the surface of said two contact areas.

4. The polysilicon resistor as recited in one of the preceding claims, wherein said P-type dopant is boron and said N-type dopant is phosphorous.

5. The polysilicon resistor as recited in claim 4, wherein said acceptor concentration of boron is greater than said donor concentration of phosphorous.

6. Method for manufacture of a P-type polysilicon resistor as recited in one of the preceding claims comprising:
   forming a polysilicon layer (44) onto a desired substrate (e.g. 40, 42);
   forming a layer of silicon dioxide (46) upon the exposed major surface of said polysilicon layer;
   ion implanting P ions (e.g. boron) and N ions (e.g. phosphorous) through said layer of silicon dioxide (46) and into said polysilicon layer, and adjusting the ion implantation dosages so that the concentration of said P-ions be higher than the concentration of said N-ions;
   annealing the structure to form said P-type polysilicon resistor which is compensated with N ions at the grain boundaries of said polysilicon resistor; and
   making electrical contacts (58, 60) to said polysilicon resistor.

Patentansprüche

1. Kompensierter Polysiliciumwiderstand, mit einer Isolierbasis (42) und einer Schicht (44) aus Polysilicium über der Isolierschicht, wobei die Polysiliciumschicht eine bestimmte Breite und Länge zwischen zwei Kontaktbereichen aufweist und folgendes enthält:
   P-Dotierungsmittel einer bestimmten Akzeptor-

Konzentration in einer im wesentlichen einheitlichen Verteilung über die Länge in der Polysiliciumschicht, sowie

N-Dotierungsmittel einer bestimmten Donator-Konzentration in einer im wesentlichen einheitlichen Verteilung über die Länge in der Polysiliciumschicht, wobei die Netto-Dotierungskonzentration die Differenz zwischen den ersten und zweiten Konzentrationen ist, so daß die Empfindlichkeit des Flächenwiderstands des Polysiliciums bei Netto-Dotierungskonzentration stark vermindert ist.

2. Polysiliciumwiderstand nach Anspruch 1, welcher außerdem eine Schicht (46) aus Siliciumoxid über der Polysiliciumschicht (44) aufweist.

3. Polysiliciumwiderstand nach Anspruch 1 oder 2, welcher weiterhin ein Kontaktdotierungsmittel des P- oder N-Typs mit höherer Konzentration aufweist, wobei dieses Kontaktdotierungsmittel in einem Teil (50, 52) der Polysiliciumschicht (44) nahe der Oberfläche der zwei Kontaktbereiche enthalten ist.

4. Polysiliciumwiderstand nach einem der vorhergehenden Ansprüche, bei dem das P-Dotierungsmittel Bor und das N-Dotierungsmittel Phosphor ist.

5. Polysiliciumwiderstand nach Anspruch 4, bei dem die Akzeptorkonzentration von Bor größer ist als die Donatorkonzentration von Phosphor.

6. Verfahren zum Herstellen eines P-Widerstands aus Polysilicium nach einem der vorhergehenden Ansprüche, folgende Schritte umfassend:

Herstellen einer Polysiliciumschicht (44) auf einem Substrat (z. B. 40, 42);

Herstellen einer Siliciumdioxidschicht (46) auf der freiliegenden Hauptfläche der Polysiliciumschicht;

Implantieren von P-Ionen (z. B. Bor) und N-Ionen (z. B. Phosphor) durch die Siliciumdioxidschicht (46) hindurch und in die Polysiliciumschicht hinein, und Dosieren der Ionenimplantation, so daß die Konzentration der P-Ionen höher ist als die der N-Ionen;

Wärmebehandlung der Struktur, so daß ein P-Widerstand aus Polysilicium entsteht, welcher an den Korngrenzen des Polysiliciumresistors mit N-Ionen kompensiert wird; und

Herstellen elektrischer Kontakte (58, 60) zum Polysiliciumwiderstand.

**Revendications**

1. Résistance en polysilicium compensée, comportant une base isolante (42) et une couche (44) de polysilicium recouvrant ladite couche isolante, ladite couche de polysilicium possédant une largeur prédéterminée, et une longueur prédéterminée entre deux zones de contact, ladite couche de polysilicium comprenant:

une substance dopante de type P possédant une concentration prédéterminée d'accepteurs et incluse dans ladite couche de polysilicium d'une manière sensiblement uniforme sur ladite longueur; et

une substance dopante de type N possédant une concentration prédéterminée de donneurs et incluse dans ladite couche de polysilicium d'une manière sensiblement uniforme sur ladite longueur, la concentration nette de la substance dopante étant égale à la différence entre lesdites première et seconde concentrations, ce qui a pour effet que la sensibilité de la résistance de couche de polysilicium vis-à-vis de la concentration nette de la substance dopante est fortement réduite.

2. Résistance en polysilicium selon la revendication 1, comportant en outre une couche (46) d'oxyde de silicium recouvrant ladite couche de polysilicium (44).

3. Résistance en polysilicium selon la revendication 1 ou 2, comportant en outre une substance dopante de contact du type substance de type P ou de type N possédant la concentration la plus élevée, ladite substance dopante de contact étant incluse dans une partie (50, 52) de ladite couche de polysilicium (44) proche de la surface desdites deux zones de contact.

4. Résistance en polysilicium selon l'une des revendications précédentes, dans laquelle ladite substance dopante de type P est du bore et ladite substance dopante de type N est du phosphore.

5. Résistance en polysilicium selon la revendication 4, dans laquelle ladite concentration d'accepteurs dans le bore est supérieure à ladite concentration de donneurs dans le phosphore.

6. Procédé pour fabriquer une résistance en polysilicium de type P selon l'une des revendications précédentes, incluant:

la formation d'une couche de polysilicium (44) sur un substrat désiré (par exemple 40, 42);

la formation d'une couche de bioxyde de silicium (46) sur la surface principale nue de ladite couche de polysilicium;

l'implantation ionique d'ions fournissant le type P (par exemple du bore) et d'ions fournissant le type N (par exemple du phosphore) à travers ladite couche de bioxyde de silicium (46) et dans ladite couche de polysilicium, et le réglage des doses d'implantation ionique de manière que la concentration desdits ions fournissant le type P soit supérieure à la concentration desdits ions fournissant le type N;

le recuit de la structure de manière à former ladite résistance en polysilicium de type P, qui est compensée par des ions fournissant le type N au niveau des limites des grains de ladite résistance en polysilicium; et

la fabrication de contacts électriques (58, 60) de liaison à ladite résistance en polysilicium.

FIG. 1

FIG.2

FIG.4

FIG.5

FIG.3